# EUROPÄISCHE PATENTSCHRIFT

(11) **EP 2 724 422 B1**
(45) Veröffentlichungstag und Bekanntmachung des Hinweises auf die Patenterteilung: **27.04.2016**
(21) Anmeldenummer: 12734798.7
(22) Anmeldetag: 15.06.2012
(51) Int. Cl.: H01R 13/6463, H01R 43/26, H01R 13/03, H01R 13/6461, H01R 13/6466, H01R 24/64, H01R 43/18, H05K 3/18

(54) **STECKER UND VERFAHREN ZU DESSEN HERSTELLUNG**
PLUG AND METHOD FOR MANUFACTURING SAME
FICHE ÉLECTRIQUE ET PROCÉDÉ DE FABRICATION CORRESPONDANT

(30) Priorität: 21.06.2011 CH 10522011
(43) Veröffentlichungstag der Anmeldung: 30.04.2014
(73) Patentinhaber: Reichle & De-Massari AG, 8622 Wetzikon (CH)
(72) Erfinder: SCHWEIZER, Dominik, 8604 Volketswil (CH)
(74) Vertreter: Daub, Thomas
(86) Internationale Anmeldenummer: PCT/EP2012/002544
(87) Internationale Veröffentlichungsnummer: WO 2012/175184

(56) Entgegenhaltungen:
- EP-A2- 1 246 308
- WO-A1-2004/082343
- DE-A1- 10 217 292
- DE-C1- 19 529 380
- US-A- 5 626 483

## Beschreibung

Die Erfindung betrifft das Gebiet der Steckverbinder für elektrische Datenübertragung. Sie betrifft insbesondere einen Stecker.

Stecker, des normierten Typs RJ-45 oder auch entsprechende Cat.7-Stecker sind meist aus vielen Einzelelementen zusammengesetzt, welche sowohl mechanische als auch elektromagnetische Funktionen erfüllen. In bekannten Steckerausführungen sind bis zu mehrere Dutzend Einzelteile enthalten. Nebst einem Gehäuse sind das Leiterplatte(n), Kontaktelemente, IDCs, Abschirmbleche etc, wobei Elemente, die miteinander in elektrischem Kontakt stehen müssen, miteinander verlötet oder verpresst sind. Das hat erhebliche Auswirkungen auf die Herstellungskosten, insbesondere durch die Assemblierung. Weiter können mechanische Toleranzen zu Problemen bezüglich der Übertragungsperformance führen.

DE-A1-10217292 offenbart einen Stecker nach dem Oberbegriff des Anspruchs 1. EP-A2-1246308 offenbart ein Verfahren zum herstellen eines Steckers wobei das Verfahren das Giessen eines dreidimensionalen Steckerkörpers aus Kunststoff aufweist.

Es ist Aufgabe der vorliegenden Erfindung, einen Stecker zur Verfügung zu stellen, welcher Nachteile des Standes der Technik überwindet und welcher insbesondere aus weniger Bauteilen aufgebaut ist und bevorzugt eine hohe Performance (also bspw. mindestens Cat.6, und insbesondere mindestens Cat.6A) erreicht.

Diese Aufgabe wird gelöst durch die Erfindung, wie sie in den Patentansprüchen definiert ist.

Gemäss einem Aspekt der Erfindung wird ein Stecker für einen elektrischen Steckverbinder zur Verfügung gestellt, der wie an sich bekannt eine Mehrzahl von Steckerkontakten aufweist, die mit einer entsprechenden Anzahl von Anschlusselementen - beispielsweise Schneidklemmen, Klemmkontakten oder eventuell auch Lötstellen - zum Anschluss je einer elektrischen Kabelader elektrisch verbunden oder verbindbar sind. Der Stecker zeichnet sich nun dadurch aus, dass pro Steckerkontakt ein elektrischer Leiter (nachfolgend "Leiter" genannt) als auf der Oberfläche eines Kunststoffteils 3-dimensional aufgewachsene, dort haftende Leiterbahn ausgebildet ist, welcher sowohl den Steckerkontakt bildet als auch diesen mit dem Anschlusselement elektrisch verbindet und eine elektromagnetische Kompensation zur Erreichung der gewünschten Performance beinhaltet,

Eine Leiterbahn verläuft dann dreidimensional, wenn sie nicht auf eine 2-dimensionale Ebene beschränkt ist (d.h. wenn es keine 2D-Ebene gibt, in welcher die ganze Bahn verläuft). Die Leiter verlaufen vorliegend auf der Oberfläche eines 3D-Körpers, welcher durch seine 3D-Ausgestaltung von einer (Leiter-)Platte (PCB) verschieden ist. Insbesondere bildet der Kunststoffkörper beispielsweise den Steckerkörper, und mindestens eine die Steckerpartie bildender Bereich des Steckerkörpers hat im Wesentlichen die von der Steckernorm geforderte Form, bildet also das Steckergesicht (wobei noch ein auf den Steckerkörper mit den Leiterbahnen aufgebrachtes Steckergehäuse vorhanden sein kann).

Der erfindungsgemässe Stecker ist im Allgemeinen ein Stecker für twisted-pair-Kabelverbindungen. Er weist bspw. mindestens zwei, mindestens vier, mindestens sechs, oder - oft mindestens acht Steckerkontakte auf. Die Steckerkontakte sind meist mindestens teilweise als parallele Streifenförmige Kontakte auf der Steckerkörper-Oberfläche ausgebildet. Sie können entweder wie bei bekannten RJ-45-Steckem oft angewendet alle parallel und auf derselben Ebene nebeneinander auf dem Steckerkörper angeordnet sein, oder es können mehrere Paare von parallelen, auf einer Ebene nebeneinander liegenden Steckerkontakten vorhanden sein, wie das bspw. bei Steckern bekannt ist die den Normen entsprechen, welche den Cat.7- und Cat.7A-Anforderungen genügen.

Der Kunststoffkörper ist im Allgemeinen in einem Giessverfahren, insbesondere im Spritzgussverfahren hergestellt. In vielen Ausführungsformen ist der Steckerkörper aus einem thermoplastischen Kunststoff oder einer Mehrzahl von thermoplastischen Kunststoffen hergestellt. Die Leiter sind mit einem aus der ,Molded Interconnect Device' (MID)-Technologie an sich bekannten Verfahren aufgebracht. Der Steckerkörper kann dann als spritzgegossener Schaltungsträger (Molded Interconnect Device MID) aufgefasst werden.

Besonders geeignet ist die Laser-Direkt-Strukturierung; auch Zweikomponentenspritzgussverfahren können verwendet werden. Beim Laser-Direkt-Strukturierungsverfahren (LDS) wird der Steckerkörper nach dem Giessen selektiv oberflächenaktiviert: Die Leiterbahnen werden mit dem Laserstrahl (bspw. einem UV-Laser) quasi auf die Oberfläche geschrieben. Daraufhin werden die Leiterbahnen in einem Bad stromlos oder galvanisch metallisiert.

Das dazu alternative Zweikomponentenspritzgussverfahren sieht vor, dass ein metallisierbarer Kunststoff die Oberflächenbereiche, an denen die Leiterbahnen entstehen sollen, bildet, und ein nicht metallisierbarer Kunststoff die übrigen Oberflächenbereiche. Dabei kann entweder der metallisierbare (dann nicht elektrisch leitende) Kunststoff den eigentlichen Körper des Kunststoffteils bilden und mit dem ersten Schuss gespritzt worden sein, oder der nicht metallisierbare Kunststoff bildet den Kunststoffkörper.

Auch weitere alternative Lösungen sind denkbar, darunter auch subtraktive Verfahren. Gegenwärtig als besonders geeignet für die Zwecke der Erfindung erscheinen LDS und Zweikomponentenspritzguss.

MID im Allgemeinen und LDS sowie Zweikomponentenspritzguss im Speziellen sind an sich bekannte Verfahren, auf deren Details hier nicht weiter eingegangen wird. Bisher waren diese Verfahren zum Herstellen von klassischen Interconnects mit speziellen räumlichen Strukturen und Herstellen von Leiterbahnen auf Gehäuseteilen, bspw. als Mobilfunkantennen bekannt. Es ist eine der Erfindung zugrunde liegende Erkenntnis, dass diese Verfahren beim Herstellen eines Steckers markante Vorteile bringen können, insbesondere bei der Verringerung der benötigten Anzahl an Bauteilen und somit zur Einsparung von Herstellungskosten.

Die Leiter verlaufen beispielsweise von den Stellen, an denen sie die Steckerkontakte bilden bis hin zu den Anschlusselementen (bspw. IDCs), so dass zwischen dem durch den Steckerkontakt zu kontaktierenden Buchsenkontakt und der Kabelader nebst dem Leiter höchstens ein die Kabelader klemmendes und/oder in diese einschneidendes, bspw. einstückiges Anschlusselement vorhanden ist. Mit anderen Worten sind die aufgewachsenen Leiter die einzigen benötigten Leiter, und der Steckerkörper mit den aufgewachsenen Leitern ersetzt eine Vielzahl von Einzelteilen (Kontaktsatz, Kompensation, Steckerkörper).

Die Leiter können abschnittweise parallel auf der Kunststoffkörperoberfläche verlaufen. Sie können insbesondere Paare - beispielsweise vier Paare - von bereichsweise parallelen Übergangsabschnitten ausbilden, welche die Steckerkontakte mit den Anschlusselementen verbinden.

Die Leiter können auf unterschiedlichen Seiten des Steckerkörpers von den Steckerkontakten (oder von der Stecker-Kontakt-Zone) hin in Richtung der Anschlusselemente (Anschlusszone) verlaufen, bspw. auf mindestens zwei Seiten (,oberseitig' und 'unterseitig'; die Bezeichnungen 'oben' und 'unten' oder dergleichen sollen natürlich keine Beschränkung der Orientierungen darstellen, in denen der Stecker genutzt werden kann) oder auf weiteren Seiten. Gegebenenfalls können zusätzlich Bereiche einiger Leiter auch entlang der distalen Endfläche geführt sein, bspw. Bereiche derjenigen Leiter, die mit entlang der Unterseite geführten weiteren Bereichen.

Die auf der Kunststoffkörperoberfläche ausgebildeten Leiter weisen auch Kompensationsbereiche auf. Solche werden durch Leiterbahnpartien gebildet, die abweichend von einer direkten Verbindung der Steckerkontakte zu den Anschlusselementen verlaufen und bspw. verästelt und/oder mäandrierend und/oder mit mehreren zueinander parallelen Bahnen ausgebildet sind, um in vorgegebener und an sich bekannter Art eine elektromagnetische (im Allgemeinen induktive und kapazitive) Kopplung zwischen Leitern zu bewirken, die nicht ein Leiterpaar des "twisted-pair"-Kabels bilden und so das Übersprechverhalten zu kompensieren. Die Kompensation des Übersprechverhaltens erfordert oft besonders fein verästelte Leiterpartien, und es ist eine Erkenntnis der Erfindung dass das Vorgehen mit auf der Oberfläche eines Kunststoffteils 3-dimensional aufgewachsenen Leiterbahnen erstens dafür gut für solche Kompensationspartien geeignet ist und dass zweitens die Vorzüge des Verfahrens dort besonders zum Tragen kommen.

In Ausführungsformen sind die Leiter auf die Oberfläche des Kunststoffkörpers beschränkt und frei von in tieferen Schichten unter der Oberfläche verlaufenden und beispielsweise über Vias mit der Oberfläche verbundenen Leiberbahnabschnitten; ebenso sind sie vorzugsweise frei von jeglichen Vias. Sie werden dann ausschliesslich durch die auf der auf der Oberfläche aufgewachsenen Leiter gebildet.

Solche mehrschichtige Ausführungen sind jedoch nicht ausgeschlossen (bspw. Zweikomponentenspritzguss).

Ein Verfahren zum Herstellen eines Steckers mit mindestens zwei, bevorzugt mindestens sechs Steckerkontakten, weist die folgenden Verfahrensschritte auf:
- Giessen des dreidimensionalen, d.h. von einer flachen Form (Plattenform) verschieden Steckerkörpers aus Kunststoff;
- Selektives Anlagern von metallischen Leiterbahnen am Steckerkörper so, dass diese Leiter bilden, die so angeordnet und ausgebildet sind, dass sie sowohl die Steckerkontakte als auch elektrische Verbindungen zwischen den Steckerkontakten und Anschlusselementen zum Anschliessen von Kabeladern bilden; und
- Anbringen eines Steckergehäuses, welches die Leiterbahnen teilweise überdeckt.

Das Steckergehäuse - das gilt unabhängig vom gewählten Verfahren - kann dem Schutz der von den Steckerkontakten verschiedenen Bereiche der Leiter dienen. Es kann zusammen mit dem Steckerkörper die Form des Steckers definieren. Weiter kann es Rastmittel, bspw. eine Rastklinke aufweisen, die mit entsprechenden Mitteln einer Buchse oder eines Adapters zusammenwirken um den Stecker zu verrasten.

Nachfolgend wird ein Ausführungsbeispiel der Erfindung anhand von Figuren im Detail beschrieben. In den Figuren bezeichnen gleiche Bezugszeichen gleiche oder analoge Elemente. Es zeigen:
- Figur 1 eine Ansicht eines Steckerkörpers für einen erfindungsgemässen Stecker;
- Figur 2 eine Ansicht eines alternativen Steckerkörpers;
- Figuren 3 und 4 je eine Ansicht eines Steckers des Typs GG45 (Cat.7 und Cat.7A); und
- Figur 5 ein Diagramm, welches die Verfahrensschritte eines Herstellungsverfahrens des Steckers zeigt.

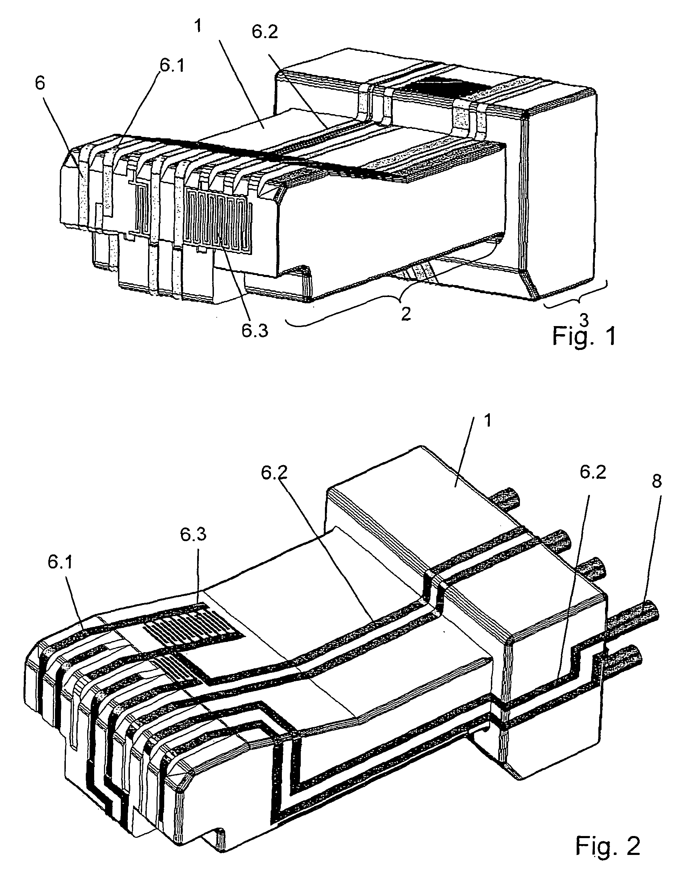

Der Steckerkörper 1 gemäss Fig. 1 ist aus einem geeigneten Thermoplasten im Spritzgussverfahren geformt. Der Thermoplast weist zwecks Eignung zum Laser-Direkt-Strukturierungsverfahren geeignete Bestandteile auf - bspw. nichtleitende Metallchelatkomplexe - so dass durch Laseraktivierung an der Oberfläche Metallisierungskeime gebildet werden können. Eine entsprechende Lehre findet man bspw. in WO 98/55669 oder in EP 1 274 288. An der Oberfläche des Steckerkörpers sind Leiterbahnen 6 ausgebildet, welche durch Abscheidung an den aktivierten Oberflächenbereichen in einem Metallisierungsbad erzeugt wurden.

Anstelle des Verfahren mittels Aktivierung einer mit Metallchelatkomplexen versehenen Oberfläche sind auch andere Verfahren von MID-Technologien denkbar, inklusive Verfahren mit vorheriger Abscheidung von Schichten (Primerschichten, Metallisierungen etc.) und dem Zweikomponentenspritzgussverfahren.

Der Steckerkörper weist eine vordere (distale) Steckerpartie 2 und eine hintere (proximale) Anschlusspartie 3 auf.

Die Leiterbahnen 6 an der Oberfläche bilden in der hier dargestellten Ausführungsform - mit Ausnahme der (bspw. IDC-) Anschlusselemente zum Anschliessen der Kabeladern - das gesamte Leitersystem des Steckers aus. Parallele, äquidistante Bereiche 6.1 der Leiterbahnen bilden dabei die Steckerkontakte wie von den Normen der RJ-45-Gruppe gefordert. Weiter weisen die Leiterbahnen 6 Übergangsbereiche 6.2 auf, welche die Steckerkontakte 6.1 mit den Anschlusselementen (in Fig. 1 nicht sichtbar) verbinden. Weiter sind Kompensationsbereiche 6.3 sichtbar, in denen die Leiterbahnen abweichend von einer direkten Verbindung der Steckerkontakte zu den Anschlusselementen verlaufen und bspw. verästelt oder mäandrierend ausgebildet sind, um in vorgegebener und an sich bekannter Art das Übersprechverhalten zu kompensieren.

Die abgebildete Ausführungsform eines RJ-45-Steckers entspricht den Spezifikationen der Kategorie 6A. Analog lassen sich auch Stecker für GG45 respektive Cat.7 und Cat.7A-Steckverbindungen herstellen.

Wie an sich von RJ-45-Steckverbindungen bekannt bilden die Leiter Leiterpaare, welche miteinander verdrillten Kabeladerpaaren der "twisted-pair"-Kabelverbindung zuzuordnen sind. Konkret bilden die Leiterpaare 1,2; 3,6; 4,5; und 7,8 je ein Paar; im dargestellten Beispiel sind die Paare 1,2 und 3,6 der Oberseite des Steckerkörpers entlang geführt und die Paare 4,5 und 7,8 entlang der Unterseite.

Der Stecker wird zusätzlich zum abgebildeten Steckerkörper mit Leiterbahnen die bereits erwähnten Anschlusselemente (bspw. IDC-Kontakte) und eventuell separate, diese haltende Steckerteile aufweisen. Weiter kann ein Steckergehäuse vorhanden sein, welches die Steckerpartie und eventuell auch die Anschlusspartie umgibt, wobei am Ort der Steckerkontakte 6.1, wie an sich von RJ-45-Steckergehäusen bekannt, Schlitze vorhanden sind, durch die federnde Buchsenkontakte eingreifen und die Steckerkontakte kontaktieren können.

Eine weitere Ausführungsform eines Steckerkörpers 1 ist in **Fig.** 2 abgebildet. Im Unterschied zur Ausführungsform von Fig. 1 sind die Kompensationsbereiche 6.3 nicht primär an der distalen Endfläche des Steckers, sondern ober- und unterseitig vorhanden, ergänzend oder alternativ sind auch laterale Kompensationsbereiche 6.3 denkbar. Auch Kombinationen dieser beiden Vorgehensweisen sind denkbar, also Kompensationsbereiche an der distalen Endfläche sowie ober- und/oder unterseitig und/oder lateral.

Den Ausführungsformen der Figuren 1 und 2 ist gemeinsam, dass nicht alle Übergangsbereiche 6.2 auf derselben Seite des Steckerkörpers verlaufen, sondern zwecks Reduktion des Übersprechverhaltens an unterschiedlichen Seiten entlang geführt sind. In Fig. 1 sind je zwei Paare von Leiter-Übergangsbereichen 6.2 auf der Ober- und auf der Unterseite angeordnet. In der Ausführungsform von Fig. 2 wird je ein Paar oberseitig, unterseitig und auf je einer lateralen Seite geführt. In der Ausführungsform von Fig. 2 sind auch Anschlusselemente 8 für die elektrischen Leiter (Kabeladem) angedeutet. Die Anschlusselemente können irgend eine vom Stand der Technik her bekannte Ausgestaltung aufweisen. Auch Anschlusselemente, welche die Leiter bildenden Metallisierungen 6 direkt nutzen - bspw. durch metallisierte Sacklöcher, in welche Kabeladern einzuführen sind, oder Kontaktierungsflächen, auf welche frei liegende Enden der Kabeladern geklemmt werden, sind im Prinzip denkbar.

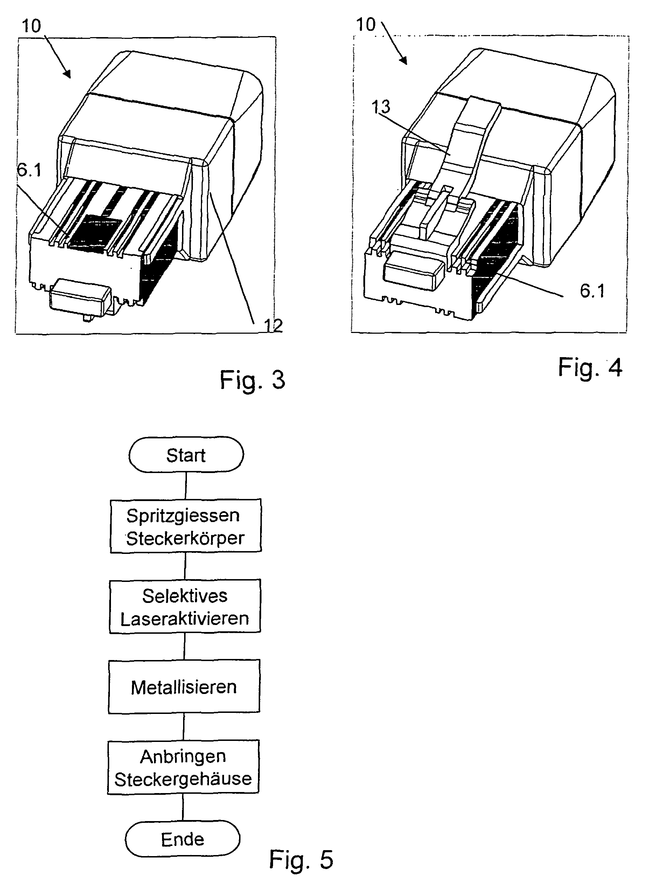

Wie in **Figuren 3 und 4** schematisch dargestellt ist, ist das erfindungsgemässe Vorgehen auch für andere Steckertypen, insbesondere für twisted-pair-Kabel, als RJ-45 geeignet. Figuren 3 und 4 zeigen schematisch einen Stecker 10 des Typs GG45, der für Cat.7-Kabel und Cat.7A-Kabel geeignet ist. Bei diesem Typ sind sowohl ober- als auch unterseitig je Steckerkontakte 6.1 ausgebildet, was einen grösseren Abstand der entsprechenden Leiter ermöglicht um das Übersprechverhalten weiter zu vermindern. Beim abgebildeten Stecker 10 ist ein Steckergehäuse 12 mit Rastklinke 13 über den Steckerkörper gelegt, von dem daher nur die in entsprechenden Schlitzen des Steckergehäuses 12 frei liegenden Steckerkontakte 6.1 sichtbar sind.

**Fig. 5** illustriert noch schematisch ein Herstellungsverfahren für einen Stecker: in einem ersten Schritt wird der Steckerkörper durch Giessen, bspw. Spritzgiessen gleich in seiner endgültigen Form hergestellt. Dann erfolgt das selektive Aktivieren der Oberfläche mit einem geeigneten Laser, und anschliessend die Metallisierung der aktivierten Oberflächenbereiche, beispielsweise im stromlosen Metallisierungsbad. Nach der erfolgten Metallisierung ist der Steckerkörper bereits fertig hergestellt. Dann wird im Allgemeinen ein Steckergehäuse befestigt, und gegebenenfalls werden Anschlusselemente befestigt (in Fig. 5 nicht dargestellt), bspw. durch Klemmen, Löten oder irgendwelche andere Anschluss-Techniken. Das Anbringen der Anschlusselemente kann vor oder nach dem Anbringen des Steckergehäuses stattfinden. Wenn die Anschlusselemente Lötstellen sind, können sie auch erst beim Beschalten angebracht werden und gehören dann nicht zum Stecker selbst.

## Patentansprüche

1. Stecker für einen elektrischen Steckverbinder, aufweisend eine Mehrzahl von Steckerkontakten (6.1) und einer elektrischen Verbindung zu einer entsprechenden Anzahl von Anschlusselementen (8) zum Anschluss je einer elektrischen Kabelader, **gekennzeichnet durch** ein einen Steckerkörper (1) bildendes, gegossenes Kunststoffteil mit einer Mehrzahl von auf der Oberfläche des Kunststoffteils haftenden, entlang einer dreidimensionalen Bahn verlaufenden Leitern (6), die so angeordnet und ausgebildet sind, dass sie sowohl die Steckerkontakte (6.1) des Steckers bilden als auch diese mit dem jeweils zugeordneten Anschlusselement (8) elektrisch verbinden als auch Kompensationspartien (6.3) zur Reduktion des Übersprechverhaltens aufweisen.

2. Stecker nach Anspruch 1, **dadurch gekennzeichnet dass** der Steckerkörper (1) im Spritzguss-Verfahren hergestellt ist.

3. Stecker nach einem der vorangehenden Ansprüche, **dadurch gekennzeichnet, dass** die Leiter (6) als metallische Leiter auf dem Steckerkörper (1) aufgetragen sind, indem in einem ersten Schritt die Oberfläche des Steckerkörpers so ausgestaltet wird, dass sie nur bereichsweise metallisierbar ist und die metallisierten Bereiche dort vorhanden sind, wo die Leiter entstehen sollen, und indem in einem zweiten Schritt die Leiter durch Metallisierung dieser Bereiche aufgetragen werden.

4. Stecker nach einem der vorangehenden Ansprüche, aufweisend mindestens acht Steckerkontakte (6.1).

5. Stecker nach einem der vorangehenden Ansprüche, **dadurch gekennzeichnet, dass** er den normierten Anforderungen an einen Stecker für twisted-pair-Kabelverbindungen, genügt.

6. Stecker nach einem der vorangehenden Ansprüche, **dadurch gekennzeichnet, dass** die Leiterbahnen auf unterschiedlichen Seiten des Steckerkörpers verlaufen.

7. Stecker nach einem der vorangehenden Ansprüche, **dadurch gekennzeichnet, dass** die Leiter (6) die Steckerkontakte (6.1) bildend diese direkt und ohne dazwischen liegende, von den Leitern verschiedene Elemente mit den Anschlusselementen (8) verbinden.

8. Stecker nach einem der vorangehenden Ansprüche, **gekennzeichnet durch** ein Steckergehäuse den Steckerkörper (1) mindestens teilweise umgebendes Steckergehäuse, welches die Leiter (6) teilweise abdeckt, wobei die Steckerkontakte (6.1) in Öffnungen des Steckergehäuses freiliegen.

9. Stecker nach Anspruch 8, **dadurch gekennzeichnet, dass** eine Form eines Steckergehäuse-Inneren mindestens bereichsweise einer äusseren Form des Steckerkörpers entspricht.

10. Verfahren zum Herstellen eines Steckers mit mindestens zwei Steckerkontakten (6.1), nach einem der vorangehenden Ansprüche, aufweisend die Verfahrensschritte:
- Giessen eines dreidimensionalen Steckerkörpers (1) aus Kunststoff;
- Selektives Anlagern von metallischen Leiterbahnen am Steckerkörper (1) so, dass diese Leiter (6) bilden, die so angeordnet und ausgebildet sind, dass sie sowohl die Steckerkontakte (6.1) als auch elektrische Verbindungen zwischen den Steckerkontakten und Anschlusselementen (8) zum Anschliessen von Kabeladern bilden; und
- Anbringen eines Steckergehäuses (12), welches die Leiterbahnen (6) teilweise überdeckt.

## Claims

1. Plug for an electric plug connector, comprising a plurality of plug contacts (6.1) and an electric connection to a corresponding number of connecting elements (8) each for connecting one electric cable core, **characterised by** a cast plastic part that forms a plug body (1) and comprises a plurality of conductors (6) adhering to the surface of the plastic part and running along a three-dimensional path, which conductors (6) are arranged and implemented in such a way that they form the plug contacts (6.1) of the plug and also electrically connect them to the respectively assigned connecting element (8) and also comprise compensation portions (6.3) for reducing crosstalk.

2. Plug according to claim 1, **characterised in that** the plug body (1) is produced in an injection molding process.

3. Plug according to one of the preceding claims, **characterised in that** the conductors (6) are applied onto the plug body (1) as metallic conductors by implementing in a first step the surface of the plug body in such a way that it is only regionally metallisable and the metallised regions are provided where the conductors are intended to emerge, and by in a second step the conductors being applied by metallisation of these regions.

4. The plug according to one of the preceding claims, comprising at least eight plug contacts (6.1).

5. Plug according to one of the preceding claims, **characterised in that** it fulfils the normed requirements pertaining to a plug for twisted-pair cable connections.

6. Plug according to one of the preceding claims, **characterised in that** the conducting tracks run on different sides of the plug body.

7. Plug according to one of the preceding claims, **characterised in that** the conductors (6) while forming the plug contacts (6.1) connect said plug contacts to the connecting elements (8) directly and without any interposed elements other than the conductors.

8. Plug according to one of the preceding claims, **characterised by** a plug housing that at least partially encompasses the plug body (1) and partially covers the conductors (6), the plug contacts (6.1) being exposed in openings of the plug housing.

9. Plug according to claim 8, **characterised in that** a shape of a plug housing interior at least regionally corresponds to an outer shape of the plug body.

10. Method for producing a plug with at least two plug contacts (6.1) according to one of the preceding claims, comprising the method steps:
- Casting a three-dimensional plug body (1) of plastic;
- Selective deposition of metallic conducting tracks on the plug body (1) in such a way that they form conductors (6) which are arranged and implemented in such a way that they form the plug contacts (6.1) and also form electrical connections between the plug contacts and connecting elements (8) for connecting cable cores; and
- mounting a plug housing (12), which partially covers the conducting tracks.

## Revendications

1. Fiche électrique pour un connecteur enfichable électrique, comportant une pluralité des contacts mâles (6.1) et une connexion électrique à un nombre correspondant des éléments connectifs (8) pour connecter respectivement un brin de fil, **caractérisée par** un composant coulé de plastique implémentant un corps de fiche (1) avec une pluralité des conducteurs (6) adhérents à la surface du composant de plastique et s'étendant le long d'un trajet tridimensionnel, les conducteurs (6) étant disposés et implémentés de cette manière qu'ils forment les contacts mâles (6.1) de la fiche et qu'ils les relient de façon électrique avec l'élément connectif (8) respectivement alloué et qu'ils comportent des parties de compensation (6.3) pour réduire le phénomène de diaphonie.

2. Fiche électrique selon la revendication 1, **caractérisée en ce que** le corps de fiche (1) est fabriqué dans un procédé de moulage par injection.

3. Fiche électrique selon l'une quelconque des revendications précédentes, **caractérisée en ce que** les conducteurs (6) sont appliqués sur le corps de fiche (1) comme des conducteurs métalliques, dans une première étape en la surface du corps de fiche étant implémentée de cette façon qu'elle est métallisable seulement par endroits et les endroits métallisés sont situés là où les conducteurs sont prévus à provenir, et dans une deuxième étape en les conducteurs étant appliqués par le biais d'une métallisation de ces endroits.

4. Fiche électrique selon l'une quelconque des revendications précédentes, comportant au moins huit contacts mâles (6.1).

5. Fiche électrique selon l'une quelconque des revendications précédentes, **caracterisée en ce qu**'elle répond aux demandes normées d'une fiche pour des connexions de fils avec paires torsadées.

6. Fiche électrique selon l'une quelconque des revendications précédentes, **caracterisée en ce que** les voies conductrices s'étendent sur des côtés différents du corps de fiche.

7. Fiche électrique selon l'une quelconque des revendications précédentes, **caracterisée en ce que** les conducteurs (6), implémentant les contacts mâles (6.1), les relient avec les éléments connectifs (8) directement, sans des éléments interposés différents des conducteurs.

8. Fiche électrique selon l'une quelconque des revendications précédentes, **caracterisée par** un boîtier de fiche lequel au moins partiellement entoure le corps de fiche (1) et recouvre les conducteurs (6) partiellement, les contacts mâles (6.1) étant déchaussés dans des apertures du boîtier de fiche.

9. Fiche électrique selon la revendication 8, **caracterisée en ce qu**'une forme d'un intérieur du boîtier de fiche corresponde au moins par endroits à une forme extérieure du boîtier de fiche.

10. Procédé de fabrication d'une fiche électrique avec au moins deux contacts mâles (6.1), selon l'une quelconque des revendications précédentes, comprenants les étapes du procédé :
- coulage d'un corps de fiche (1) tridimensionnel de plastique ;
- déposition sélective des voies conductrices métalliques au corps de fiche (1) de cette façon qu'elles forment des conducteurs (6) disposés et implémentés de cette manière qu'ils forment les contacts mâles (6.1) et aussi forment des connexions électriques entre les contacts mâles et des éléments connectifs (8) pour connecter des brins de fil ; et
- montage d'un boîtier de fiche (12) partiellement couvrant les voies conductrices (6).
